# FASCICULE DE BREVET EUROPEEN

(11) **EP 4 480 001 B1**
(45) Date de publication et mention de la délivrance du brevet: **17.12.2025**
(21) Numéro de dépôt: 22836236.4
(22) Date de dépôt: 19.12.2022
(51) Int. Cl.: H01L 21/762, H01L 21/18

(54) **PROCEDE DE TRANSFERT D'UNE COUCHE MINCE SUR UN SUBSTRAT SUPPORT**
VERFAHREN ZUM ÜBERTRAGEN EINES DÜNNFILMS AUF EIN TRÄGERSUBSTRAT
METHOD FOR TRANSFERRING A THIN FILM ONTO A SUPPORT SUBSTRATE

(30) Priorité: 14.02.2022 FR 2201259
(43) Date de publication de la demande: 25.12.2024
(73) Titulaire: SOITEC, 38190 Bernin (FR); Commissariat à l'Energie Atomique et aux Energies Alternatives, 75015 Paris (FR)
(72) Inventeur: COLAS, Franck, 38190 BERNIN (FR); BROEKAART, Marcel, 38190 BERNIN (FR); BEN MOHAMED, Nadia, 38190 BERNIN (FR); MAZEN, Frédéric, 38054 GRENOBLE CEDEX 9 (FR); LANDRU, Didier, 38190 BERNIN (FR); ACOSTA ALBA, Pablo, 38054 GRENOBLE CEDEX 9 (FR); KONONCHUK, Oleg, 38190 BERNIN (FR); LARREY, Vincent, 38054 GRENOBLE CEDEX 9 (FR)
(74) Mandataire: IP Trust
(86) Numéro de dépôt international: PCT/EP2022/086746
(87) Numéro de publication internationale: WO 2023/151852

(56) Documents cités:
- FR-A1- 3 109 016
- US-A1- 2010 330 779
- US-A1- 2012 145 667

## Description

### DOMAINE DE L'INVENTION

La présente invention vise le domaine de la microélectronique et des semi-conducteurs. En particulier, l'invention concerne un procédé de transfert d'une couche mince sur un substrat support, basé sur la technologie Smart Cut^{™}, la couche mince présentant une rugosité améliorée après séparation. Le procédé de transfert peut notamment être mis en œuvre pour la fabrication d'une structure SOI.

### ARRIÈRE PLAN TECHNOLOGIQUE DE L'INVENTION

La technologie Smart Cut^{™} est bien connue pour la fabrication de structures SOI (silicium sur isolant) et plus généralement, pour le transfert de couches minces. Cette technologie est basée sur la formation d'un plan fragile enterré dans un substrat donneur, par implantation d'espèces légères dans ledit substrat ; le plan fragile enterré délimite, avec une face avant du substrat donneur, la couche mince à transférer. Un assemblage intervient ensuite entre le substrat donneur et un substrat support, au niveau de leurs faces avant respectives, pour former un ensemble collé. L'assemblage est avantageusement réalisé par collage direct, par adhésion moléculaire, c'est-à-dire sans implication de matière adhésive : une interface de collage est ainsi établie entre les deux substrats assemblés. La croissance de microfissures dans le plan fragile enterré, par activation thermique, peut conduire à une séparation spontanée, le long dudit plan, donnant lieu au transfert de la couche mince sur le substrat support (formant la structure empilée). Le reste du substrat donneur peut être réutilisé pour un transfert de couche ultérieur. Après séparation, il est habituel d'appliquer des traitements de finition à la structure empilée, pour restaurer la qualité cristalline et la rugosité de surface de la couche mince transférée. Ces étapes de finition peuvent notamment impliquer des traitements thermiques d'oxydation ou de lissage (en atmosphère neutre ou réductrice), des nettoyages et/ou gravures chimiques et/ou des étapes de polissage mécano-chimiques, comme cela est connu de l'homme du métier. Enfin, différents outils d'inspection de la structure finale permettent de contrôler l'intégralité de la surface de la couche mince.

Lorsque la séparation dans le plan fragile enterré est spontanée, on observe des variabilités importantes en termes de rugosité de surface de la couche mince transférée, tant dans les hautes fréquences (microrugosité) que dans les basses fréquences (ondulations, zones locales de forte rugosité, marbrures, etc). Ces variabilités sont visibles et mesurables en particulier via les outils d'inspection précités, lors du contrôle de la couche mince dans la structure finale.

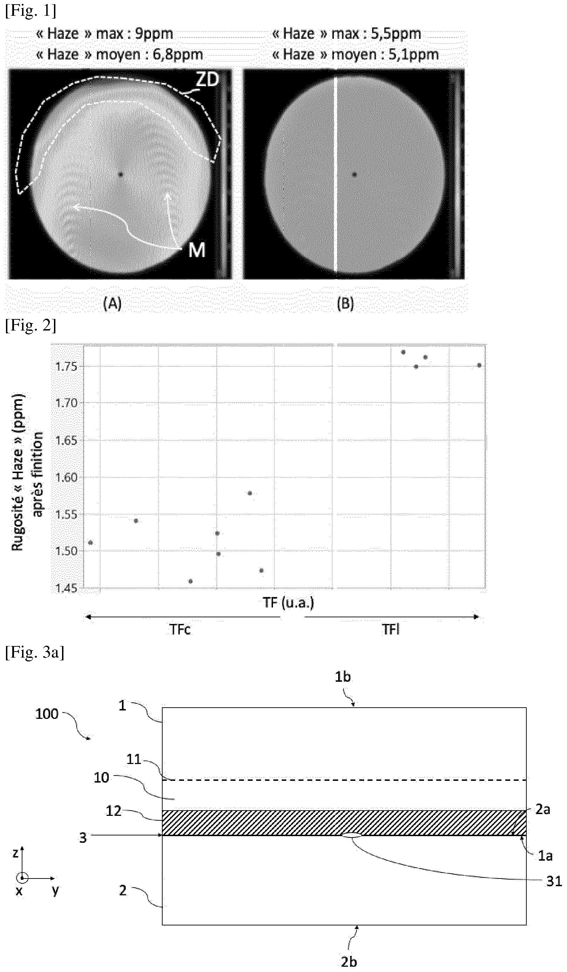

Rappelons que la rugosité de surface de la couche mince après finition peut être imagée par une cartographie obtenue à l'aide d'un outil d'inspection Surfscan^{™} de la société KLA-Tencor ([Fig.1]). Le niveau de rugosité ainsi que de potentiels motifs (marbrures (M), zones denses (ZD)...) sont mesurés ou rendus apparents par la mesure de bruit de fond diffus (« haze » selon la terminologie anglo-saxonne communément employée) correspondant à l'intensité de la lumière diffusée par la surface de la couche mince. Le signal de « haze » varie linéairement avec le carré de la rugosité de surface RMS (rugosité moyenne quadratique) dans la gamme de fréquences spatiales de 0,1µm ⁻¹ à 10µm⁻¹. On pourra se référer à l'article « Seeing through the haze », de F. Holsteyns (Yield Management Solution, Spring 2004, pp50-54) pour une information plus complète sur cette technique d'inspection et d'évaluation de la rugosité sur une grande surface.

Les cartographies de la [Fig.1] montrent la rugosité de surface de deux couches minces transférées à partir de deux ensembles collés et traités à l'identique jusqu'à la finition. Sur la cartographie (A), on observe une zone périphérique de rugosité résiduelle, dite « zone dense (ZD) » (en particulier, en haut de la cartographie) ; la cartographie (B) en est totalement dépourvue. Des marbrures (M) plus marquées sont également apparentes sur la cartographie (A). Les rugosités moyennes et maximales (exprimées en ppm de « haze ») sont en outre significativement différentes entre les deux cartographies (A) et (B). La [Fig.1] illustre les variabilités de qualité et rugosité finales des couches minces, qui trouvent principalement leur origine dans les variabilités de rugosité de surface (hautes et basses fréquences) après séparation.

Pour améliorer la qualité des couches minces dans la structure empilée finale, il demeure donc toujours important de réduire la rugosité de surface (quelle que soit la fréquence spatiale) de ces couches, après transfert.

Il est connu du document US2010/330779 de former une zone locale non collée, à l'interface de collage, bordée par une région collée, pour constituer un déclencheur de la séparation et ainsi limiter la rugosité d'une couche mince de silicium transférée sur un substrat support en verre. La zone locale non collée est obtenue par la réalisation d'une topologie correspondant à une cavité et/ou à un dôme (ou pic), sur la face à assembler du substrat donneur (silicium) ou du substrat support (verre). Des cavités et/ ou des pics de l'ordre de 2 à 3 micromètres sont réalisés sur le substrat de verre, pour induire une zone non collée de plusieurs dizaines de mm².

### OBJET DE L'INVENTION

La présente invention propose un procédé de transfert mettant en œuvre un point initiateur de fracture particulier, permettant l'obtention d'une rugosité de surface de la couche mince améliorée après séparation, pour atteindre une excellente qualité de surface après les étapes de finition de la structure empilée. Le procédé est en particulier avantageux pour la fabrication de structures SOI.

### BREVE DESCRIPTION DE L'INVENTION

La présente invention concerne un procédé de transfert d'une couche mince sur un substrat support, comprenant :
- la fourniture d'un ensemble collé comportant un substrat donneur et le substrat support, assemblés par collage direct au niveau de leurs faces avant respectives, suivant une interface de collage, l'ensemble collé présentant une zone locale non collée au sein de cette interface de collage, le substrat donneur comprenant en outre un plan fragile enterré,
- la séparation le long du plan fragile enterré, initiée au niveau de la zone locale non collée après une croissance de microfissures dans ledit plan par activation thermique, la séparation menant au transfert d'une couche mince issue du substrat donneur sur le substrat support.

Le procédé est remarquable en ce que la zone locale non collée est uniquement générée par une zone rugueuse réalisée à dessein sur l'une au moins des faces avant des substrats donneur et support avant leur assemblage, ladite zone rugueuse étant exempte de topologie et présentant une rugosité prédéterminée d'amplitude comprise entre 0,5nm RMS exclu et 60,0nm RMS exclu.

Selon des caractéristiques avantageuses de l'invention, prises seules ou selon toute combinaison réalisable :
- la zone rugueuse est réalisée par au moins un tir laser générant uniquement une fusion superficielle, dans les 1 à 30 premiers nanomètres, d'un matériau composant le substrat donneur et/ou le substrat support, du côté de leur face avant respective,
- le tir laser a une durée d'impulsion comprise entre 1 ns et 1000 ns, préférentiellement comprise entre 10 ns et 500 ns.
- le tir laser est effectué avec un laser de longueur d'onde 308nm, et avec une densité d'énergie comprise entre 1,8 J/cm² et 2,5 J/cm² ;
- un tir laser irradie une surface circulaire, de diamètre inférieur à 200 micromètres ;
- la zone rugueuse est réalisée à partir d'une pluralité de tirs lasers, par exemple entre deux et quinze tirs lasers, les surfaces circulaires adjacentes irradiées par les tirs lasers successifs étant tangentes ou présentant un pourcentage de recouvrement entre 1% et 95% ;
- la face avant, sur laquelle la zone rugueuse est réalisée, est en silicium monocristallin, et la rugosité prédéterminée a une amplitude comprise entre 0,5nm RMS et 4,0nm RMS, préférentiellement comprise entre 1,0nm RMS et 2,5nm RMS ;
- la face avant, sur laquelle la zone rugueuse est réalisée, est en silicium poly-cristallin, et la rugosité prédéterminée a une amplitude comprise entre 0,5nm RMS et 5,0nm RMS, préférentiellement comprise entre 2,0nm RMS et 5,0nm RMS ;
- la face avant, sur laquelle la zone rugueuse est réalisée, est en oxyde de silicium, et la rugosité prédéterminée a une amplitude comprise entre 1,0nm RMS et 60,0nm RMS ;
- la zone rugueuse est réalisée sur la face avant du substrat donneur, avant la formation du plan fragile enterré dans ledit substrat donneur ;
- le substrat donneur est formé d'un premier matériau au niveau de sa face avant, et une zone rugueuse préliminaire est réalisée en surface dudit matériau, et une oxydation thermique du premier matériau du substrat donneur est effectuée après la réalisation de la zone rugueuse préliminaire et avant la formation du plan fragile enterré, pour former une couche isolante qui sera assemblée sur le substrat support dans l'ensemble collé, ladite couche isolante comportant, sur sa face libre, la zone rugueuse à l'aplomb de la zone rugueuse préliminaire ;
- le substrat support est formé d'un premier matériau au niveau de sa face avant, et une zone rugueuse préliminaire est réalisée en surface dudit matériau, et une oxydation thermique du premier matériau du substrat support est effectuée après la réalisation de la zone rugueuse préliminaire, pour former une couche isolante qui sera assemblée sur le substrat donneur dans l'ensemble collé, ladite couche isolante comportant, sur sa face libre, la zone rugueuse à l'aplomb de la zone rugueuse préliminaire ;
- la zone locale non collée présente une forme, dans le plan de l'interface de collage, dont au moins une portion du contour a un rayon de courbure inférieur au rayon d'un défaut de collage circulaire de même surface ;
- la zone locale non collée présente au moins une dimension latérale, dans le plan de l'interface de collage, inférieure à 300 micromètres ;
- la zone locale non collée est localisée dans une région centrale de l'ensemble collé, dans le plan de l'interface de collage ;
- le plan fragile enterré est formé dans le substrat donneur par implantation d'espèces légères telles que l'hydrogène, l'hélium ou une combinaison de ces deux espèces ;
- le substrat donneur et/ou le substrat support présentent une couche isolante au moins du côté de leur face avant respective, qui forme une couche isolante enterrée, adjacente à l'interface de collage, dans l'ensemble collé ;
- la couche mince, issue du substrat donneur, est en silicium monocristallin et le substrat support comprend du silicium monocristallin, pour former une structure empilée de type SOI.

### Brève description des dessins

D'autres caractéristiques et avantages de l'invention ressortiront de la description détaillée qui va suivre en référence aux figures annexées sur lesquelles :
[Fig.1] La [Fig.1] présente deux cartographies représentatives de la rugosité de surface de deux couches minces transférées, issues de deux ensembles collés et traités à l'identique jusqu'à la finition, selon un procédé classique ; les deux cartographies ont été obtenues via un outil d'inspection Surfscan^{™} ;
[Fig.2] La [Fig.2] présente un graphe indiquant la rugosité de surface des couches minces, en fonction du temps de fracture, pour une pluralité d'ensembles collés (différents des ensembles collés énoncés en référence à la [Fig.1]) et traités de manière identique jusqu'à la finition, selon un procédé classique ;
[Fig.3a] La [Fig.3a] présente un ensemble collé intervenant à une étape intermédiaire du procédé de transfert conforme à l'invention ;
[Fig.3b] La [Fig.3b] présente un exemple de substrat donneur ou support comprenant une zone rugueuse formée à dessein sur sa face avant, conformément au procédé de transfert de l'invention, laquelle zone rugueuse présente une rugosité prédéterminée ;
[Fig.4] La [Fig.4] présente une structure empilée et le reste d'un substrat donneur, obtenus par un procédé de transfert conforme à l'invention ;
[Fig.5] La [Fig.5] présente l'évolution de la rugosité RMS (moyenne quadratique) et PV (crête à creux) d'une surface en silicium irradiée par un tir laser, en fonction de la densité d'énergie du laser ;
[Fig.6] La [Fig.6] présente deux cartographies représentatives de la rugosité de surface (après finition) de deux couches minces transférées pour une première et une deuxième structure RFSOI, la première (110) ayant été obtenue avec un procédé de transfert conforme à l'invention, la deuxième (110') avec un procédé de transfert classique ; les deux cartographies ont été obtenues via un outil d'inspection Surfscan^{™} ;
[Fig.7] La [Fig.7] présente différents exemples de formes de la zone rugueuse et de la zone locale non collée associée, mises en œuvre dans le procédé de transfert conforme à l'invention ;
[Fig.8a]

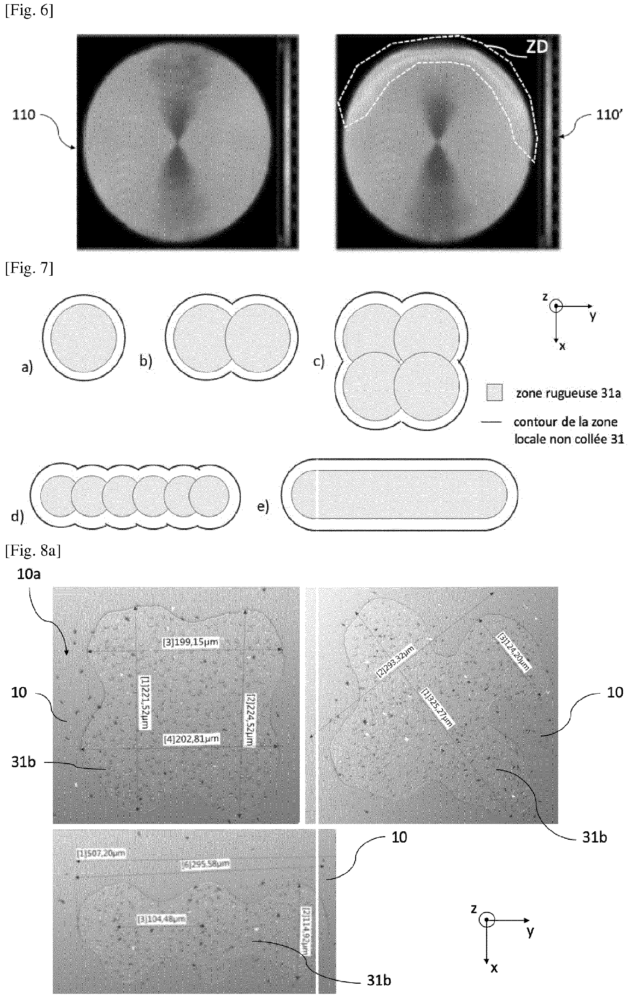

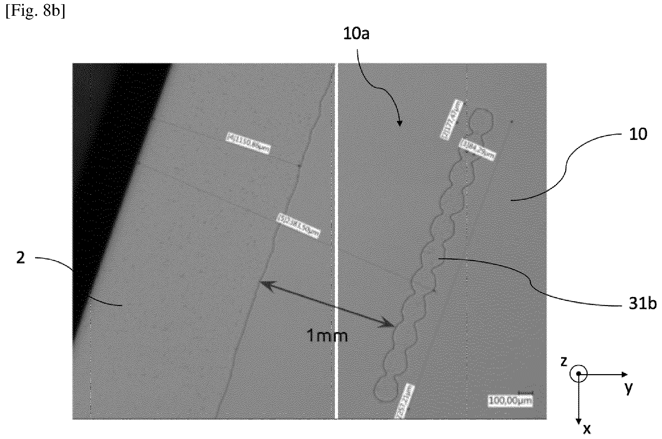

[Fig.8b] Les figures 8a et 8b présentent des images de zone non transférée correspondant à la zone locale non collée d'un ensemble collé ; la zone non transférée étant observée sur une structure empilée obtenue par un procédé de transfert conforme à l'invention.

Certaines figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

Les mêmes références sur les figures et dans la description pourront être utilisées pour des éléments de même nature.

### DESCRIPTION DETAILLEE DE L'INVENTION

L'invention concerne un procédé de transfert d'une couche mince sur un substrat support, pour former une structure empilée. Comme évoqué en introduction, une telle structure empilée peut notamment être de type SOI, et comprendre une couche mince superficielle en silicium, une couche isolante intermédiaire en oxyde de silicium et un substrat support en silicium. Le substrat support peut optionnellement comporter d'autres couches fonctionnelles, telle qu'une couche de piégeage de charges, par exemple pour des structures SOI destinées à des applications radiofréquences (RF). Le procédé de transfert selon l'invention n'est néanmoins pas limité à la fabrication de SOI et peut être appliqué à nombre d'autres structures empilées dans le domaine de la microélectronique, des microsystèmes et des semi-conducteurs.

Le procédé de transfert selon l'invention est basé sur la technologie Smart Cut^{™}. Lorsque la séparation dans le plan fragile enterré est spontanée, le temps de fracture (c'est-à-dire le temps au bout duquel la séparation intervient, lors du recuit thermique de fracture) peut différer entre une pluralité d'ensembles collés traités à l'identique, subissant le même recuit, dans le même four. Le temps de fracture (TF) dépend d'une multitude de paramètres, liés à la formation du plan fragile enterré, au recuit de fracture, à la nature de l'ensemble collé, etc. La demanderesse a remarqué que, pour des ensembles collés préparés de façon similaire et subissant un même recuit de fracture, les séparations qui interviennent en des temps de fracture courts (TFc) donnent lieu à des rugosités de surface hautes fréquences (microrugosité) de couches minces dans les structures empilées finales (c'est-à-dire après transfert et finition) plus faibles que les séparations intervenant en des temps de fracture plus longs (TFl), comme cela est visible sur la [Fig.2]. En outre, les temps de fracture longs induisent une zone locale de rugosité très élevée (appelée zone dense ZD) en bord de couche mince après fracture, ce qui est peu ou pas le cas lorsque le temps de fracture est court. Cette zone dense dégrade la qualité et la rugosité de la couche mince, même après finition, comme cela est visible sur la cartographie (A) de la [Fig.1].

Le procédé de transfert selon l'invention vise donc à amorcer, de façon anticipée (temps de fracture court) et répétable (faible dispersion du temps de fracture entre une pluralité d'ensembles collés similaires), la séparation spontanée dans le plan fragile enterré, de manière à améliorer substantiellement la rugosité de surface de la couche mince transférée.

Pour cela, le procédé de transfert comprend, en premier lieu, la fourniture d'un ensemble collé 100 comportant un substrat donneur 1 et le substrat support 2, assemblés par collage direct au niveau de leurs faces avant respectives (1a,2a), suivant une interface de collage 3 ([Fig.3a]).

Le substrat donneur 1 se présente préférentiellement sous la forme d'une plaquette de diamètre 100mm, 150mm, 200mm, 300mm voire 450mm et d'épaisseur comprise typiquement entre 300µm et 1mm. Il comporte une face avant 1a et une face arrière 1b. La rugosité de surface de la face avant 1a est choisie inférieure à 1,0nm RMS, voire préférentiellement inférieure à 0,5nm RMS (mesurée par microscopie à force atomique (AFM), par exemple sur un scan de 20µm x 20µm). Le substrat donneur 1 peut être en silicium ou en tout autre matériau semi-conducteur ou isolant, pour lequel un transfert de couche mince peut présenter un intérêt (par exemple, SiC, GaN, composés III-V, matériaux piézoélectriques, etc). Notons également que le substrat donneur 1 pourra comporter une ou plusieurs couches supplémentaires 12, au moins du côté de sa face avant 1a, par exemple une couche isolante. Comme illustré sur la [Fig.3a], cette couche supplémentaire 12 devient une couche intermédiaire enterrée dans l'ensemble collé 100, après assemblage du substrat donneur 1 et du substrat support 2.

Le substrat donneur 1 comprend un plan fragile enterré 11, qui délimite une couche mince 10 à transférer. Comme cela est bien connu en référence à la technologie Smart Cut^{™}, un tel plan fragile enterré 11 peut être formé par implantation d'espèces légères, telles que l'hydrogène, l'hélium ou une combinaison de ces deux espèces. Les espèces légères sont implantées à une profondeur déterminée dans le substrat donneur 1, cohérente avec l'épaisseur de la couche mince 10 visée. Ces espèces légères vont former, autour de la profondeur déterminée, des microcavités distribuées dans une fine couche sensiblement parallèle à la face avant 1a du substrat donneur 1, soit parallèle au plan (x,y) sur les figures. On appelle cette fine couche le plan fragile enterré 11, par souci de simplification.

L'énergie d'implantation des espèces légères est choisie de manière à atteindre la profondeur déterminée. Par exemple, des ions hydrogène seront implantés à une énergie comprise entre 10 keV et 210 keV, et à une dose comprise entre 5E16/cm² et 1E17/cm², pour délimiter une couche mince 10 présentant une épaisseur de l'ordre de 100nm à 1500nm. Rappelons qu'une couche supplémentaire pourra être déposée sur la face avant 1a du substrat donneur 1, préalablement à l'étape d'implantation ionique. Cette couche supplémentaire peut être composée par un matériau tel que l'oxyde de silicium ou le nitrure de silicium par exemple. Elle peut être conservée pour l'étape suivante d'assemblage (et former tout ou partie de la couche intermédiaire de l'ensemble collé 100), ou elle peut être retirée.

Le substrat support 2 se présente également préférentiellement sous la forme d'une plaquette de diamètre 100mm, 150mm, 200mm, 300mm voire 450mm et d'épaisseur comprise typiquement entre 300µm et 1mm. Il comporte une face avant 2a et une face arrière 2b. La rugosité de surface de la face avant 2a est choisie inférieure à 1,0nm RMS, voire préférentiellement inférieure à 0,5nm RMS (mesurée par AFM, par exemple sur un scan de 20µm x 20µm). Le substrat support 2 peut être en silicium ou en tout autre matériau semi-conducteur ou isolant, sur lequel un transfert de couche mince peut présenter un intérêt (par exemple, SiC, GaN, composés III-V, matériaux piézoélectriques, matériaux isolants, etc). On note également que le substrat support 2 peut comporter une ou plusieurs couches supplémentaires, au moins du côté de sa face avant 2a, par exemple une couche isolante et/ou une couche de piégeage de charges. Cette (ou ces) couche(s) supplémentaire(s) se retrouvent enterrées dans l'ensemble collé 100, après assemblage du substrat donneur 1 et du substrat support 2.

L'assemblage entre les substrats donneur 1 et support 2 est basé sur un collage direct par adhésion moléculaire. Comme cela est bien connu en soi, un tel collage ne nécessite pas une matière adhésive, car des liaisons s'établissent à l'échelle atomique entre les surfaces assemblées, formant l'interface de collage 3. Plusieurs types de collage par adhésion moléculaire existent, qui diffèrent notamment par leurs conditions de température, de pression, d'atmosphère ou de traitements, préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

L'étape d'assemblage peut comprendre, avant la mise en contact des faces avant 1a,2a à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 3 (faible dé-fectivité, forte énergie d'adhésion).

L'ensemble collé 100 selon l'invention présente la particularité de comprendre une zone locale non collée 31 au sein de l'interface de collage 3 ([Fig.3a]). En d'autres termes, cette zone locale non collée 31 est bordée par l'interface de collage 3, laquelle est fermée, traduisant les forces d'adhésion moléculaire qui unissent les faces avantla,2a des substrats 1,2 assemblés.

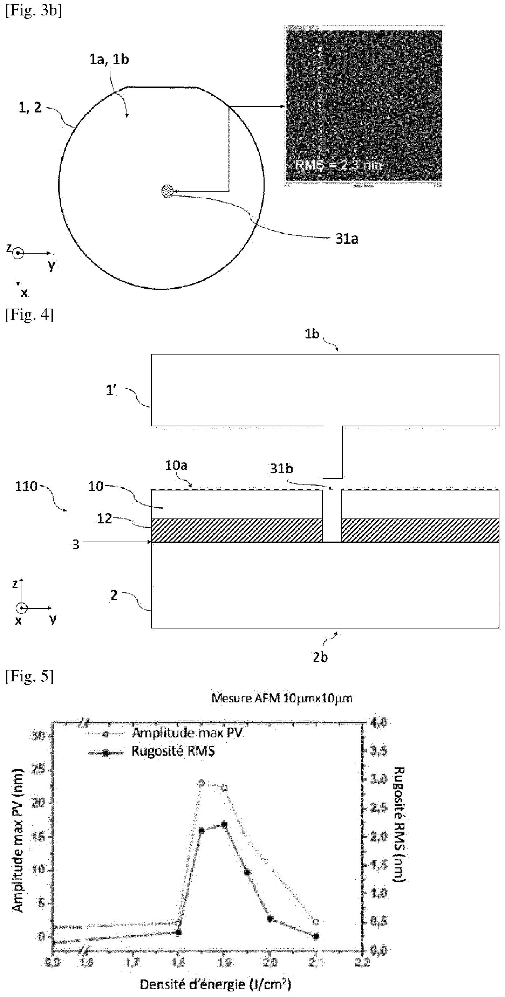

La zone locale non collée 31 est uniquement générée par la présence d'une zone rugueuse 31a, réalisée à dessein sur l'une au moins des faces avant 1a,2a des substrats donneur 1 et support 2, avant leur assemblage ([Fig.3b]). La zone rugueuse 31a est exempte de toute topologie ou ondulation à basses fréquences, c'est-à-dire dont la longueur d'onde typique serait supérieure à 100nm. Elle présente une rugosité prédéterminée hautes fréquences, qui est supérieure à la rugosité des faces avant 1a,2a autour de cette zone rugueuse 31a. La rugosité des faces avant 1a,2a peut typiquement varier en fonction de la nature des matériaux desdites faces 1a,2a et en fonction du type de collage direct mis en œuvre, mais permet toujours d'obtenir une interface collée (fermée), alors que la rugosité prédéterminée dans la zone rugueuse 31a empêche le collage local entre les deux faces 1a,2a.

L'amplitude de la rugosité prédéterminée est strictement supérieure à 0,5nm RMS et strictement inférieure à 60,0nm RMS, avec des longueurs d'onde typiques comprises entre 10nm à 100nm (correspondant à une microrugosité hautes fréquences). Comme cela est bien connu, la dénomination RMS (« root mean square ») correspond à une valeur moyenne quadratique de rugosité. La technique de mesure de cette microrugosité est la microscopie à force atomique (AFM), sur des scans de 10x10µm² à 30x30µm². Rappelons que la zone rugueuse 31a ne présente pas de topologie qui correspondrait à une ondulation à basses fréquences, mais uniquement une microrugosité dans la gamme de fréquences spatiales énoncée ci-dessus. L'amplitude maximale crête à creux ou PV (pour « peak to valley ») dans la zone rugueuse 31a est typiquement comprise entre 5,0nm et 300,0nm, préférentiellement entre 5,0nm et 60,0nm.

En particulier, sur l'exemple de la [Fig.3b], la zone rugueuse 31a présente une rugosité de 2,3nm RMS et 25nm PV, mesurée par AFM sur un scan de 10µm x 10µm (image à droite sur la [Fig.3b]).

Selon un mode de réalisation particulier notamment mis en œuvre pour la fabrication de structures SOI, la face avant 1a,2a, sur laquelle la zone rugueuse 31a est réalisée, est en silicium monocristallin, et la rugosité prédéterminée a préférentiellement une amplitude comprise entre 0,5nm RMS et 4,0nm RMS (typiquement, 5,0nm PV à 40,0nm PV). Encore préférentiellement, cette amplitude est comprise entre 1,0nm RMS et 2,5nm RMS (typiquement 10,0nm PV à 25,0nm PV), voire entre 1,5nm RMS et 2,5nm RMS.

Selon un autre mode de réalisation avantageux, la face avant 1a,2a du substrat 1,2, sur laquelle la zone rugueuse 31a est réalisée, est en silicium poly-cristallin, et la rugosité prédéterminée a une amplitude comprise entre 0,5nm RMS et 5,0nm RMS (typiquement, 5,0nm PV à 60,0nm PV). Encore préférentiellement, cette amplitude est comprise entre 2,0nm RMS et 5,0nm RMS (typiquement 20,0nm PV à 60,0nm PV). Ce mode de réalisation est particulièrement intéressant pour la fabrication de structures SOI adaptées aux applications RF, pour lesquelles le substrat support 2 comprend, du côté de sa face avant 2a, une couche de piégeage de charges en silicium poly-cristallin.

Selon encore un autre mode de réalisation, la face avant 1a,2a, sur laquelle la zone rugueuse 31a est réalisée, est en oxyde de silicium, et la rugosité prédéterminée a une amplitude comprise entre 1,0nm RMS et 60,0nm RMS.

Notons que, lorsque c'est la face avant 1a du substrat donneur 1 qui porte la zone rugueuse 31a, cette dernière est préférentiellement réalisée avant la formation du plan fragile enterré 11 dans ledit substrat 1, pour limiter tout endommagement ou murissement précoce des microcavités le composant.

Il est également envisageable de réaliser une zone rugueuse préliminaire sur un premier matériau formant le substrat donneur 1, au niveau de sa face avant ; par exemple le premier matériau peut être du silicium. Une oxydation thermique du premier matériau du substrat donneur 1 est ensuite effectuée, pour former une couche isolante (par exemple en oxyde de silicium). L'épaisseur de la couche isolante pourra par exemple être inférieure ou égale à 200nm. Ladite couche isolante (correspondant à la couche supplémentaire 12 illustrée sur la [Fig.3a]) comporte sur sa face libre (la face avant 1a du substrat donneur 1), la zone rugueuse 31a à l'aplomb de la zone rugueuse préliminaire élaborée dans le premier matériau. En effet, l'oxydation conserve au moins en partie la rugosité hautes fréquences que présente le premier matériau dans la zone rugueuse préliminaire : on s'attachera à former une microrugosité dans la zone rugueuse préliminaire apte à donner lieu à une rugosité prédéterminée de la zone rugueuse 31a après oxydation, dans la gamme d'amplitudes précitées. Après la formation du plan fragile enterré 11 dans le substrat donneur 1, la couche isolante 12 est assemblée sur le substrat support 2 dans l'ensemble collé 100 et la zone rugueuse 31a génère la zone locale non collée 31 au sein de l'interface de collage 3. Dans ce cas de figure, la zone rugueuse 31a sur la face avant 1a du substrat donneur 1 n'a pas été directement réalisée par « rugosification » de la couche isolante 12 mais est issue d'une zone rugueuse préliminaire présente dans un matériau sous-jacent.

Même si la formation de cette zone rugueuse préliminaire a été décrite en référence au substrat donneur 1, elle pourrait bien sûr être appliquée au substrat support 2.

L'ensemble collé 100 étant formé et comportant la zone locale non collée 31 au sein de son interface de collage 3, le procédé de transfert selon l'invention prévoit de lui appliquer un recuit thermique qui va donner lieu à une séparation spontanée le long du plan fragile enterré 11. La séparation mène au transfert de la couche mince 10 issue du substrat donneur 1 sur le substrat support 2, pour former la structure empilée 110 ( [Fig.4]). Une zone non transférée 31b, au niveau de laquelle la couche mince 10 n'a pas été reportée, est présente à l'aplomb de l'emplacement de la zone locale non collée 31. On obtient par ailleurs le reste du substrat donneur 1'.

La zone locale non collée 31 agit comme un point initiateur de la fracture, dans le plan fragile enterré 11 et à l'aplomb ou à proximité de ladite zone 31, après une croissance de microfissures dans le plan fragile enterré 11 par activation thermique. Cette initiation de fracture apparaît de manière anticipée par rapport à un ensemble collé 100 qui ne comporterait pas la zone locale non collée 31 : cela donne accès à des temps de fracture courts, qui procurent des rugosités de surface faibles, après transfert, au niveau de la face 10a de la couche mince 10. Des exemples, détaillés plus loin, montrent une amélioration nette de la rugosité de surface après transfert, du fait de temps de fracture courts obtenus grâce à la zone locale non collée 31 qui agit comme un point initiateur de fracture ([Fig.6], structure empilée 110).

La zone locale non collée 31 selon l'invention se distingue de l'état de la technique en ce qu'elle est uniquement due à la présence d'une zone rugueuse 31a sur la face avant 1a,2a de l'un ou l'autre des substrats donneur 1 et support 2. Aucune topologie à basses fréquences n'est impliquée (bosses, trous, cavités, particules). Le volume interne de la zone locale non collée 31 ainsi créée est extrêmement faible ; de fait, l'accumulation, dans ce volume interne, de différents gaz issus notamment de la vaporisation des monocouches d'eau présentes sur les faces 1a,2a assemblées ou de l'exo-diffusion d'espèces légères par la face avant 1a du substrat donneur 1, autorise une mise sous pression rapide et favorable à l'initiation de la fracture dès que le niveau de murissement des microfissures dans le plan fragile enterré 11 le permet.

La zone locale non collée 31 peut être localisée à différentes positions dans le plan de l'interface de collage 3 : notamment, dans une région centrale de l'ensemble collé 100 ou dans une région périphérique ou encore dans une région intermédiaire entre ces deux extrêmes. Dans la région périphérique, il est préférable que la zone locale non collée 31 se trouve au moins à 1mm de la couronne périphérique (non collée) de l'ensemble collé 100. Rappelons que la couronne non collée (visible sur la [Fig.8b]) est liée à la présence d'une tombée de bords et d'un chanfrein en bord des substrats 1,2 assemblés.

La demanderesse a observé que le positionnement de la zone locale non collée 31 au centre, ou dans une région centrale de l'ensemble collé 100 (comme par exemple illustré sur la [Fig.3b]) permettait non seulement de réduire la rugosité finale (« haze ») de la couche mince transférée 10, sur l'ensemble de sa surface, mais également de limiter drastiquement, voire d'éliminer, la zone dense ZD, qui correspond à une zone périphérique locale de rugosité très élevée ([Fig.6]).

La zone locale non collée 31 peut présenter différentes formes, dans le plan de l'interface de collage 3 (soit dans le plan (x,y)). Certains exemples sont illustrés sur la [Fig.7].

Avantageusement, la zone locale non collée 31 présente une forme, dans le plan (x,y), dont au moins une portion du contour a un rayon de courbure inférieur au rayon d'un défaut de collage circulaire de même surface (figures 7 (b), (c), (d)). La demanderesse a mis en évidence qu'un contour présentant localement des rayons de courbure faibles, des parties rectilignes ou des points singuliers (tels que des points de rebroussement par exemple), donnait à la zone locale non collée 31 une excellente efficacité pour l'initiation de la fracture : des temps de fracture courts et peu dispersés entre une pluralité d'ensembles collés identiques peuvent donc être obtenus, donnant lieu à des rugosités de surface de couches minces 10 faibles, uniformes et reproductibles.

Les figures 8a et 8b présentent des images prises au microscope optique de zones non transférées 31b (générées par des zones locales non collées 31) sur des structures empilées 110 obtenues par le procédé de transfert de l'invention. Ces zones 31b présentent des contours avec des formes particulières telles qu'évoquées précédemment en référence à l'efficacité accrue de la zone locale non collée 31 en tant que point initiateur de fracture.

Pour éviter de pénaliser l'intégrité du transfert de la couche mince 10, la zone locale non collée 31 présente avantageusement au moins une dimension latérale, dans le plan (x,y), inférieure à 300 micromètres. Cela est typiquement obtenu en formant une zone rugueuse 31a, sur l'une des faces avant 1a,2a des substrats 1,2, avec une dimension latérale associée inférieure ou égale à 200 micromètres.

La zone rugueuse 31a peut être réalisée par différentes techniques, notamment par gravure chimique, humide ou sèche, opérée après avoir protégé la face avant 1a,2a concernée, à l'exception de la zone que l'on souhaite rendre rugueuse.

Il est néanmoins avantageux de former cette zone rugueuse en limitant au maximum le contact avec le reste de la face avant 1a,2a concernée, de manière à réduire les risques de contamination ou de dégradation (rayures...) de cette face, destinée à être assemblée.

Une technique particulièrement avantageuse de formation de la zone rugueuse 31a consiste en la mise en œuvre d'un tir laser, apte à générer uniquement une fusion superficielle du matériau de la face avant 1a,2a, et ce uniquement dans la zone à rendre rugueuse. Cette fusion superficielle s'opère typiquement dans les quelques premiers nanomètres du matériau de la face avant 1a,2a, entre 1nm et 30nm : on se situe donc dans un régime en limite de fusion et pas du tout dans des régimes d'ablation qui retirent du matériau ou le creusent. Le tir laser mis en œuvre ici ne crée aucune topologie, ni cavité ni bosse, uniquement une rugosité hautes fréquences, dans les gammes RMS et PV précitées.

Préférentiellement, le tir laser est donc effectué sur une très courte impulsion, soit une durée comprise typiquement entre 1ns et 1000ns, plus avantageusement entre 10ns et 500ns. La longueur d'onde du laser utilisé pourra être choisie entre 100nm et 550nm, de préférence entre 250nm et 400nm.

A titre d'exemple, lorsque le matériau est le silicium, le tir laser peut être réalisé avec un laser de longueur d'onde 308nm, et avec une densité d'énergie comprise entre 1,8 J/cm² et 2,5 J/cm². La [Fig.5] présente des courbes reliant la rugosité (RMS et PV) d'une surface en silicium monocristallin, irradiée par un tir laser (longueur d'onde 308 nm, durée d'impulsion 160 ns), avec la densité d'énergie du tir laser. Il est important de se situer dans un régime en limite de fusion (dans cet exemple, à 1,9 +/- 0,1 J/cm²), pour générer une rugosité hautes fréquences d'amplitude attendue. Ce régime correspond à une fusion « discontinue » de la surface irradiée ; cela veut dire que l'on induit des zones fondues et des zones non fondues au niveau de cette surface, favorables à la formation de la rugosité hautes fréquences recherchée. Une trop faible densité d'énergie (< 1,8 J/cm²) ne permet pas d'atteindre la fusion et il n'est pas généré de rugosité ou trop peu ; une trop forte densité d'énergie (> 2 J/cm²) provoque une fusion « homogène » de toute la surface irradiée, qui recristallise uniformément avec une rugosité potentiellement trop restreinte.

Notons que dans le cas où le matériau de la face avant 1a,2a (qui va subir le tir laser) est un oxyde de silicium et que le matériau sous-jacent est du silicium, le tir laser passe à travers la couche d'oxyde de silicium et va générer une fusion du silicium, laquelle va induire la formation de rides à la surface de l'oxyde. Ces rides forment la rugosité hautes fréquence attendue, dans la région irradiée, sur la face avant 1a,2a.

Comme évoqué précédemment à propos d'une dimension latérale maximale préférentielle de la zone locale non collée 31, le tir laser irradie une surface en général circulaire ayant un diamètre avantageusement inférieur à 200 micromètres. La zone rugueuse 31a générée, après un tir laser, est sensiblement de la taille de la surface irradiée.

Pour générer des formes avantageuses de la zone locale non collée 31, la zone rugueuse 31a peut être réalisée à partir d'une pluralité de tirs lasers, par exemple, deux ([Fig.7] (b)), trois, quatre ([Fig.7] (c)), cinq, six ([Fig.7] (d)) voire quinze tirs lasers. Pour induire une unique zone locale non collée 31 avec une forme particulière et non une pluralité de zones 31 circulaires, les surfaces irradiées par les tirs lasers successifs doivent au moins être tangentes ; elles peuvent également présenter un certain pourcentage de recouvrement (entre 1% et 95%, ou entre 20% et 70%). Comme illustré sur les figures 7 (b), (c), (d), il est ainsi possible de former des contours de zone locale non collée 31 favorables à une amorce de fracture, car présentant des points singuliers ou des faibles rayons de courbure localement ; avec un recouvrement de l'ordre de 50%, il est possible de former une zone rugueuse 31a avec une forme de capsule ( [Fig.7] (e)) : une portion du contour de la zone locale non collée 31 générée présente ainsi une portion rectiligne, ce qui la rend efficace pour amorcer la fracture.

Les formes de zone rugueuse 31a et de zone locale non collée 31 énoncées ne sont bien sûr pas exhaustives et toute autre forme géométrique ou quelconque pourrait être envisagée.

### Exemples de mise en œuvre :

Selon un premier exemple, le procédé de transfert est mis en œuvre pour élaborer une structure FDSOI (SOI totalement déplété, ou « fully depeleted SOI » selon la terminologie anglo-saxonne), c'est-à-dire présentant une faible épaisseur de couche mince superficielle et une faible épaisseur de couche isolante enterrée.

Le substrat donneur 1 est une plaquette en silicium monocristallin de 300mm de diamètre, et comprend au niveau de sa face avant 1a, une couche isolante 12 en oxyde de silicium d'épaisseur 35nm. Le plan fragile enterré 11 est formé par co-implantation d'ions hélium et hydrogène à des énergies respectives de 40 keV et 25 keV, et à des doses respectives à 1E16 /cm² et 1E16/cm².

Le substrat support 2 est une plaquette en silicium monocristallin de diamètre 300mm.

Un tir laser est effectué au centre du substrat support 2, du côté de sa face avant 2a, de manière à provoquer une fusion / recristallisation de la surface uniquement, dans un régime en limite de fusion. Les conditions laser sont les suivantes : longueur d'onde 308nm, durée de l'impulsion laser 160ns, densité d'énergie 1,9J/cm², surface irradiée quasi-circulaire de rayon 65µm. Un tir laser conduit donc à la formation d'une zone rugueuse au niveau de la surface irradiée, avec une rugosité RMS de 2,3nm +/-0,5nm, mesurée par AFM sur scan de 10x10µm² (voir par exemple l'image AFM de la [Fig.3b]).

Une préparation de surface classique (nettoyages, activation plasma) des deux substrats 1,2 est ensuite effectuée en vue d'un collage par adhésion moléculaire.

L'assemblage, basé sur la mise en contact direct entre les faces avant 1a,2a des substrats donneur 1 et support 2, permet d'obtenir un ensemble collé 100. L'ensemble collé 100 comprend une zone locale non collée 31 à l'aplomb de la zone rugueuse 31a (au centre de l'ensemble collé 100), au sein de l'interface de collage 3. La zone locale non collée 31 présente un diamètre de l'ordre de 130 à 250µm.

Un recuit de fracture, opéré dans un four horizontal (apte à traiter une pluralité d'ensembles collés 100 de manière collective), est appliqué entre 200°C et 400°C.

La zone locale non collée 31 permet d'initier la fracture le long du plan fragile enterré 11 dans un temps court, c'est-à-dire environ 25% du temps de fracture moyen en l'absence de la zone locale non collée 31, dans le cas d'un recuit isotherme. En considérant une pluralité d'ensembles collés 100 traités collectivement, la zone locale non collée 31 permet en outre d'obtenir des temps de fracture moins dispersés.

La structure SOI 110 obtenue après séparation présente une zone non transférée 31b en lieu et place de la zone locale non collée 31 de l'ensemble collé 100, et dont la taille est sensiblement la même que celle de ladite zone 31.

La qualité de surface 10a de la couche mince 10 transférée est améliorée par rapport à une structure SOI 110' obtenue à partir d'un ensemble collé classique, sans zone locale non collée 31. Cela est particulièrement visible après l'application des étapes de finition (traitements thermiques d'oxydation et de lissage, principalement) pour guérir la couche mince 10 transférée et lisser sa surface : les structures SOI 110 obtenues par le procédé de l'invention ne montrent pas de zones denses de rugosité en périphérie de couche mince 10, au contraire de certaines structures SOI 110' obtenues par un procédé classique (sans zone locale non collée 31).

Selon un deuxième exemple, le procédé de transfert est mis en œuvre pour élaborer une structure RFSOI (SOI pour applications radiofréquences), c'est-à-dire présentant une couche mince superficielle, une couche isolante et une couche de piégeage de charge sur le substrat support 2.

Le substrat donneur 1 est une plaquette en silicium monocristallin de 300mm de diamètre, et comprend au niveau de sa face avant 1a, une couche isolante 12 en oxyde de silicium d'épaisseur 200nm. Le plan fragile enterré 11 est formé par co-implantation d'ions hydrogène et hélium à des énergies respectives de 35 keV et 50 keV, et à des doses respectives à 1.2E16 /cm² et 1.1E16 /cm².

Le substrat support 2 est une plaquette en silicium monocristallin de diamètre 300mm. Une couche de piégeage de charges en silicium poly-cristallin d'environ 1µm d'épaisseur est disposée sur le substrat support 2, du côté de sa face avant 2a.

Un tir laser est effectué dans une région périphérique du substrat support 2, du côté de sa face avant 2a (donc sur le silicium poly-cristallin), de manière à provoquer une fusion / recristallisation de la surface uniquement. En particulier, le tir laser est opéré à une distance comprise entre 3mm et 10mm, par exemple 5mm, du bord du substrat support 2.

Les conditions laser sont les suivantes : longueur d'onde 308nm, durée de l'impulsion laser 160ns, densité d'énergie 1,9J/cm², surface irradiée quasi-circulaire de rayon 65µm. Un tir laser conduit donc à la formation d'une zone rugueuse au niveau de la surface irradiée, avec une rugosité RMS de 2,7nm +/-0,5nm, mesurée par AFM sur scan de 10x10µm².

Une préparation de surface classique (nettoyages, activation plasma) des deux substrats 1,2 est ensuite effectuée en vue d'un collage par adhésion moléculaire.

L'assemblage, basé sur la mise en contact direct entre les faces avant 1a,2a des substrats donneur 1 et support 2, permet d'obtenir un ensemble collé 100. L'ensemble collé 100 comprend une zone locale non collée 31, à l'aplomb de la zone rugueuse 31a (en bord de l'ensemble collé 100), au sein de l'interface de collage 3. La zone locale non collée 31 présente un diamètre de l'ordre de 130 à 250µm.

Un recuit de fracture, opéré dans un four horizontal (apte à traiter une pluralité d'ensembles collés 100 de manière collective) est appliqué entre 200°C et 550°C.

La zone locale non collée 31 permet d'initier la fracture le long du plan fragile enterré 11 dans un temps court (environ 30% du temps de fracture moyen sans zone locale non collée 31). En considérant une pluralité d'ensembles collés 100 traités collectivement, la zone locale non collée 31 permet en outre d'obtenir des temps de fracture moins dispersés.

La structure SOI 110 obtenue après séparation présente une zone non transférée en lieu et place de la zone locale non collée 31 de l'ensemble collé 100, et dont la taille est sensiblement la même que celle de ladite zone 31, typiquement inférieure à 250µm.

La qualité de surface 10a de la couche mince 10 transférée est améliorée par rapport à une structure SOI 110' obtenue à partir d'un ensemble collé classique, sans zone locale non collée 31. Cela est particulièrement visible après l'application des étapes de finition (traitements thermiques d'oxydation et de lissage, principalement) pour guérir la couche mince 10 transférée et lisser sa surface : la cartographie en [Fig.6] de la structure SOI 110 obtenue par le procédé de l'invention montre une absence de zone dense de rugosité en périphérie de couche mince 10, au contraire de la structure SOI 110' obtenu un procédé classique (sans zone locale non collée 31) ; elle montre aussi un niveau global de rugosité plus faible sur l'ensemble de la surface de la couche mince 10 de la structure SOI 110.

Selon un troisième exemple, le procédé de transfert est mis en œuvre pour élaborer une structure SOI, c'est-à-dire présentant une couche mince superficielle, une couche isolante et un substrat support 2.

Le substrat donneur 1 est une plaquette en silicium monocristallin de 300mm de diamètre.

Un tir laser est effectué dans une région centrale ou périphérique du substrat donneur 1, du côté de sa face avant 1a (donc sur le silicium), de manière à provoquer une fusion / recristallisation de la surface uniquement. Les conditions laser sont les suivantes :
longueur d'onde 308nm, durée de l'impulsion laser 160ns, densité d'énergie 1,9J/cm², surface irradiée quasi-circulaire de rayon 65µm. Un tir laser conduit donc à la formation d'une zone rugueuse préliminaire au niveau de la surface irradiée, avec une rugosité RMS de 2,3nm +/-0,5nm, mesurée par AFM sur scan de 10x10µm².

Après l'application d'un nettoyage standard au substrat donneur 1, une oxydation thermique est effectuée, typiquement dans la gamme de températures 900°C - 1050°C. A l'issue de cette oxydation, le substrat donneur 1 comprend au niveau de sa face avant 1a, une couche isolante 12 en oxyde de silicium d'épaisseur 100nm. A l'aplomb de la zone rugueuse préliminaire, une zone rugueuse 31a est présente sur la face libre 1a de la couche isolante 12. Cette zone rugueuse 31a présente une rugosité RMS sensiblement identique à celle de la zone rugueuse préliminaire, soit environ 2,2nm +/-0,5nm (AFM sur scan de 10x10µm²).

Le plan fragile enterré 11 est formé par co-implantation d'ions hydrogène et hélium à des énergies respectives de 35 keV et 50 keV, et à des doses respectives à 1.2E16/cm² et 1.1E16/cm², à travers la couche isolante 12, dans le substrat donneur 1.

Le substrat support 2 est une plaquette en silicium monocristallin de diamètre 300mm.

Une préparation de surface classique (nettoyages, activation plasma) des deux substrats 1,2 est ensuite effectuée en vue d'un collage par adhésion moléculaire.

L'assemblage, basé sur la mise en contact direct entre les faces avant 1a,2a des substrats donneur 1 et support 2, permet d'obtenir un ensemble collé 100. L'ensemble collé 100 comprend une zone locale non collée 31, à l'aplomb de la zone rugueuse 31a, au sein de l'interface de collage 3. La zone locale non collée 31 présente un diamètre de l'ordre de 100 µm.

Un recuit de fracture, opéré dans un four horizontal (apte à traiter une pluralité d'ensembles collés 100 de manière collective) est appliqué entre 200°C et 550°C.

La zone locale non collée 31 permet d'initier la fracture le long du plan fragile enterré 11 dans un temps court (environ 30% du temps de fracture moyen sans zone locale non collée 31). En considérant une pluralité d'ensembles collés 100 traités collectivement, la zone locale non collée 31 permet d'obtenir des temps de fracture moins dispersés.

La structure SOI 110 obtenue après séparation présente une zone non transférée en lieu et place de la zone locale non collée 31 de l'ensemble collé 100, et dont la taille est sensiblement la même que celle de ladite zone 31, typiquement inférieure à 200µm.

La qualité de surface 10a de la couche mince 10 transférée est améliorée par rapport à une structure SOI 110' obtenue à partir d'un ensemble collé classique, sans zone locale non collée 31 : elle montre une absence de zone dense ZD de rugosité en périphérie de couche mince 10, ainsi qu'un niveau global de rugosité plus faible sur l'ensemble de la surface de la couche mince 10.

Selon un quatrième exemple, le procédé de transfert est mis en œuvre pour élaborer une structure RFSOI (SOI pour applications radiofréquences), c'est-à-dire présentant une couche mince superficielle, une couche isolante et une couche de piégeage de charge sur le substrat support 2.

Le substrat donneur 1 est une plaquette en silicium monocristallin de 200mm de diamètre, et comprend au niveau de sa face avant 1a, une couche isolante 12 en oxyde de silicium d'épaisseur 400nm. Le plan fragile enterré 11 est formé par implantation d'ions hydrogène à une énergie de 50 keV, et à une dose de 6E16 /cm².

Le substrat support 2 est une plaquette en silicium monocristallin de diamètre 200mm. Une couche de piégeage de charges en silicium poly-cristallin d'environ 2µm d'épaisseur est disposée sur le substrat support 2, du côté de sa face avant 2a.

Une pluralité de tirs lasers successifs est effectuée dans une région périphérique du substrat support 2, du côté de sa face avant 2a (donc sur le silicium poly-cristallin), de manière à provoquer une fusion / recristallisation superficielle uniquement. En particulier, le tir laser est opéré à une distance comprise entre 3mm et 10mm, par exemple 5mm, du bord du substrat support 2.

Les conditions laser sont les suivantes : longueur d'onde 308nm, durée de l'impulsion laser 160ns, densité d'énergie 2J/cm², surface irradiée quasi-circulaire de rayon 65µm, pour chaque tir laser. Une succession de onze tirs lasers, alignés, avec environ 10% de recouvrement des surfaces irradiées adjacentes, conduit à la formation d'une zone rugueuse 31a présentant une forme similaire à celle de la figue 7 (d). La rugosité RMS dans la zone rugueuse est d'environ 3nm +/-0,5nm, mesurée par AFM sur scan de 10x10µm².

Une préparation de surface classique (nettoyages, activation plasma) des deux substrats 1,2 est ensuite effectuée en vue d'un collage par adhésion moléculaire.

L'assemblage, basé sur la mise en contact direct entre les faces avant 1a,2a des substrats donneur 1 et support 2, permet d'obtenir un ensemble collé 100. L'ensemble collé 100 comprend une zone locale non collée 31 à l'aplomb de la zone rugueuse 31a, au sein de l'interface de collage 3. La zone locale non collée 31 présente, dans le plan de l'interface de collage (plan (x,y) une longueur de l'ordre de 2mm et une largeur de l'ordre de 100 à 250µm.

Un recuit de fracture, opéré dans un four horizontal est appliqué entre 200°C et 550°C.

La zone locale non collée 31 permet d'initier la fracture le long du plan fragile enterré 11 dans un temps court (environ 30% du temps de fracture moyen sans zone locale non collée 31). En considérant une pluralité d'ensembles collés 100 traités collectivement, la présence de la zone locale non collée 31 permet également d'obtenir des temps de fracture moins dispersés.

La structure SOI 110 obtenue après séparation présente une zone non transférée 31b en lieu et place de la zone locale non collée 31 de l'ensemble collé 100, et dont la taille est sensiblement la même que celle de ladite zone 31 ([Fig.8b]).

La qualité de surface 10a de la couche mince 10 transférée est ici encore améliorée par rapport à une structure SOI obtenue à partir d'un ensemble collé classique, sans zone locale non collée 31.

Notons qu'une zone locale non collée 31 présentant la forme particulière décrite dans le quatrième exemple apporte également les avantages précités lorsqu'elle est mise en œuvre dans les ensembles collés 100 décrits dans les premier, deuxième et troisième exemples.

Bien sûr, l'invention n'est pas limitée aux modes de réalisation décrits et on peut y apporter des variantes de réalisation sans sortir du cadre de l'invention tel que défini par les revendications.

## Revendications

1. Procédé de transfert d'une couche mince (10) sur un substrat support (2), comprenant :
- la fourniture d'un ensemble collé (100) comportant un substrat donneur (1) et le substrat support (2), assemblés par collage direct au niveau de leurs faces avant (1a,2a) respectives, suivant une interface de collage (3), l'ensemble collé (100) présentant une zone locale non collée (31) au sein de cette interface de collage (3), le substrat donneur (1) comprenant en outre un plan fragile enterré (11),
- la séparation le long du plan fragile enterré (11), initiée au niveau de la zone locale non collée (31) après une croissance de microfissures dans ledit plan (11) par activation thermique, la séparation menant au transfert d'une couche mince (10) issue du substrat donneur (1) sur le substrat support (2),
le procédé étant **caractérisé en ce que** la zone locale non collée (31) est uniquement générée par une zone rugueuse (31a) réalisée à dessein sur l'une au moins des faces avant (1a,2a) des substrats donneur (1) et support (2) avant leur assemblage, ladite zone rugueuse (31a) étant exempte de topologie et présentant une rugosité prédéterminée d'amplitude comprise entre 0,5nm RMS et 60,0nm RMS.

2. Procédé de transfert selon la revendication précédente, dans lequel la zone rugueuse est réalisée par au moins un tir laser générant uniquement une fusion superficielle, dans les 1 à 30 premiers nanomètres, d'un matériau composant le substrat donneur (1) et/ou le substrat support (2), du côté de leur face avant respective (1a,2a).

3. Procédé de transfert selon la revendication précédente, dans lequel le tir laser a une durée d'impulsion comprise entre 1 ns et 1000 ns, préférentiellement comprise entre 10 ns et 500 ns.

4. Procédé de transfert selon la revendication précédente, dans lequel le tir laser est effectué avec un laser de longueur d'onde 308nm, et avec une densité d'énergie comprise entre 1,8 J/cm² et 2,5 J/cm².

5. Procédé de transfert selon l'une des trois revendications précédentes, dans lequel un tir laser irradie une surface circulaire, de diamètre inférieur à 200 micromètres.

6. Procédé de transfert selon la revendication précédente, dans laquelle la zone rugueuse (31a) est réalisée à partir d'une pluralité de tirs lasers, par exemple entre deux et quinze tirs lasers, les surfaces circulaires adjacentes irradiées par les tirs lasers successifs étant tangentes ou présentant un pourcentage de recouvrement entre 1% et 95%.

7. Procédé de transfert selon l'une des revendications précédentes, dans lequel :
- la face avant (1a,2a), sur laquelle la zone rugueuse (31a) est réalisée, est en silicium monocristallin, et la rugosité prédéterminée a une amplitude comprise entre 0,5nm RMS et 4,0nm RMS, préférentiellement comprise entre 1,0nm RMS et 2,5nm RMS, ou
- la face avant (1a,2a), sur laquelle la zone rugueuse (31a) est réalisée, est en silicium poly-cristallin, et la rugosité prédéterminée a une amplitude comprise entre 0,5nm RMS et 5,0nm RMS, préférentiellement comprise entre 2,0nm RMS et 5,0nm RMS, ou
- la face avant (1a,2a), sur laquelle la zone rugueuse (31a) est réalisée, est en oxyde de silicium, et la rugosité prédéterminée a une amplitude comprise entre 1,0nm RMS et 60,0nm RMS.

8. Procédé de transfert selon l'une des revendications précédentes, dans lequel la zone rugueuse (31a) est réalisée sur la face avant (1a) du substrat donneur (1), avant la formation du plan fragile enterré (11) dans ledit substrat donneur (1).

9. Procédé de transfert selon la revendication précédente, dans lequel :
- le substrat donneur (1) est formé d'un premier matériau au niveau de sa face avant (1a), et une zone rugueuse préliminaire est réalisée en surface dudit matériau, et
- une oxydation thermique du premier matériau du substrat donneur (1) est effectuée après la réalisation de la zone rugueuse préliminaire et avant la formation du plan fragile enterré (11), pour former une couche isolante qui sera assemblée sur le substrat support (2) dans l'ensemble collé (100), ladite couche isolante comportant, sur sa face libre, la zone rugueuse (31a) à l'aplomb de la zone rugueuse préliminaire.

10. Procédé de transfert selon l'une des revendications 1 à 7, dans lequel :
- le substrat support (2) est formé d'un premier matériau au niveau de sa face avant (2a), et une zone rugueuse préliminaire est réalisée en surface dudit matériau, et
- une oxydation thermique du premier matériau du substrat support (2) est effectuée après la réalisation de la zone rugueuse préliminaire, pour former une couche isolante qui sera assemblée sur le substrat donneur (1) dans l'ensemble collé (100), ladite couche isolante comportant, sur sa face libre, la zone rugueuse (31a) à l'aplomb de la zone rugueuse préliminaire.

11. Procédé de transfert selon l'une des revendications précédentes, dans lequel la zone locale non collée (31) présente une forme, dans le plan de l'interface de collage (3), dont au moins une portion du contour a un rayon de courbure inférieur au rayon d'un défaut de collage circulaire de même surface.

12. Procédé de transfert selon l'une des revendications précédentes, dans lequel la zone locale non collée (31) présente au moins une dimension latérale, dans le plan de l'interface de collage (3), inférieure à 300 micromètres.

13. Procédé de transfert selon l'une des revendications précédentes, dans lequel la zone locale non collée (31) est localisée dans une région centrale de l'ensemble collé (100), dans le plan de l'interface de collage (3).

14. Procédé de transfert selon l'une des revendications précédentes, dans lequel la couche mince (10), issue du substrat donneur (1), est en silicium monocristallin et le substrat support (2) comprend du silicium monocristallin, pour former une structure empilée (110) de type SOI.

## Patentansprüche

1. Verfahren zum Übertragen eines Dünnfilms (10) auf ein Trägersubstrat (2), umfassend:
- die Bereitstellung einer verklebten Anordnung (100), die ein Donatorsubstrat (1) und das Trägersubstrat (2) umfasst, die durch direktes Kleben an ihren jeweiligen Vorderseiten (1a, 2a) entlang einer Klebschnittstelle (3) zusammengefügt sind, wobei die verklebte Anordnung (100) einen lokalen nicht verklebten Bereich (31) innerhalb dieser Klebschnittstelle (3) aufweist, wobei das Donatorsubstrat (1) außerdem eine vergrabene zerbrechliche Ebene (11) umfasst,
- die Trennung entlang der vergrabenen zerbrechlichen Ebene (11), die in dem lokalen nicht verklebten Bereich (31) nach einem Wachstum von Mikrorissen in der Ebene (11) durch thermische Aktivierung eingeleitet wird, wobei die Trennung zur Übertragung eines Dünnfilms (10) von dem Donatorsubstrat (1) auf das Trägersubstrat (2) führt, wobei das Verfahren **dadurch gekennzeichnet ist, dass** der lokale, nicht verklebte Bereich (31) nur durch einen rauen Bereich (31a) erzeugt wird, der gezielt auf mindestens einer der Vorderseiten (1a, 2a) der Donator- (1) und Trägersubstrate (2) vor deren Zusammenbau hergestellt wird, wobei der raue Bereich (31a) frei von Topologie ist und eine vorbestimmte Rauigkeit mit einer Amplitude zwischen 0,5 nm RMS und 60,0 nm RMS aufweist.

2. Verfahren zum Übertragen nach dem vorstehenden Anspruch, wobei der raue Bereich durch mindestens einen Laserschuss hergestellt wird, der nur eine Oberflächenschmelze innerhalb der ersten 1 bis 30 Nanometer eines Materials erzeugt, das das Donatorsubstrat (1) und/oder das Trägersubstrat (2) auf der Seite ihrer jeweiligen Vorderseite (1a, 2a) bildet.

3. Verfahren zum Übertragen nach dem vorstehenden Anspruch, wobei der Laserschuss eine Impulsdauer zwischen 1 ns und 1000 ns, vorzugsweise zwischen 10 ns und 500 ns, hat.

4. Verfahren zum Übertragen nach dem vorstehenden Anspruch, wobei der Laserschuss mit einem Laser der Wellenlänge 308 nm und mit einer Energiedichte zwischen 1,8 J/cm² und 2,5 J/cm² durchgeführt wird.

5. Verfahren zum Übertragen nach einem der drei vorstehenden Ansprüche, wobei ein Laserschuss eine kreisförmige Fläche bestrahlt, die einen Durchmesser von weniger als 200 Mikrometern hat.

6. Verfahren zum Übertragen nach dem vorstehenden Anspruch, wobei der raue Bereich (31a) aus einer Vielzahl von Laserschüssen, beispielsweise zwischen zwei und fünfzehn Laserschüssen, hergestellt wird, wobei benachbarte kreisförmige Oberflächen, die von aufeinanderfolgenden Laserschüssen bestrahlt werden, tangential sind oder eine prozentuale Überlappung zwischen 1% und 95% aufweisen.

7. Verfahren zum Übertragen nach einem der vorstehenden Ansprüche, wobei :
- die Vorderseite (1a, 2a), auf der der raue Bereich (31a) ausgebildet ist, aus monokristallinem Silizium besteht und die vorbestimmte Rauheit eine Amplitude zwischen 0,5 nm RMS und 4,0 nm RMS, vorzugsweise zwischen 1,0 nm RMS und 2,5 nm RMS, aufweist, oder
- die Vorderseite (1a, 2a), auf der der raue Bereich (31a) ausgebildet ist, aus polykristallinem Silizium besteht und die vorbestimmte Rauheit eine Amplitude zwischen 0,5 nm RMS und 5,0 nm RMS, vorzugsweise zwischen 2,0 nm RMS und 5,0 nm RMS, aufweist, oder
- die Vorderseite (1a, 2a), auf der der raue Bereich (31a) ausgebildet ist, aus Siliziumoxid besteht und die vorbestimmte Rauheit eine Amplitude zwischen 1,0 nm RMS und 60,0 nm RMS aufweist.

8. Verfahren zum Übertragen nach einem der vorstehenden Ansprüche, wobei der raue Bereich (31a) auf der Vorderseite (1a) des Donatorsubstrats (1) vor der Bildung der vergrabenen zerbrechlichen Ebene (11) in dem Donatorsubstrat (1) hergestellt wird.

9. Verfahren zum Übertragen nach dem vorstehenden Anspruch, wobei:
- das Donatorsubstrat (1) an seiner Vorderseite (1a) aus einem ersten Material gebildet ist und ein vorläufiger rauer Bereich auf der Oberfläche des Materials ausgebildet ist, und
- eine thermische Oxidation des ersten Materials des Donatorsubstrats (1) nach der Herstellung des vorläufigen rauen Bereichs und vor der Bildung der vergrabenen zerbrechlichen Ebene (11) durchgeführt wird, um eine Isolierschicht zu bilden, die auf dem Trägersubstrat (2) in der verklebten Anordnung (100) montiert wird, wobei die Isolierschicht auf ihrer freien Seite den rauen Bereich (31a) senkrecht zu dem vorläufigen rauen Bereich aufweist.

10. Verfahren zum Übertragen nach einem der Ansprüche 1 bis 7, wobei:
- das Trägersubstrat (2) an seiner Vorderseite (2a) aus einem ersten Material gebildet ist und ein vorläufiger rauer Bereich auf der Oberfläche dieses Materials hergestellt ist, und
- eine thermische Oxidation des ersten Materials des Trägersubstrats (2) nach der Herstellung des vorläufigen rauen Bereichs durchgeführt wird, um eine Isolierschicht zu bilden, die auf dem Donatorsubstrat (1) in der verklebten Anordnung (100) montiert wird, wobei die Isolierschicht auf ihrer freien Seite den rauen Bereich (31a) senkrecht zu dem vorläufigen rauen Bereich aufweist.

11. Verfahren zum Übertragen nach einem der vorstehenden Ansprüche, wobei der lokale nicht verklebte Bereich (31) in der Ebene der Klebgrenzfläche (3) eine Form aufweist, von der mindestens ein Teil der Kontur einen Krümmungsradius aufweist, der kleiner ist als der Radius eines kreisförmigen Klebfehlers mit der gleichen Fläche.

12. Verfahren zum Übertragen nach einem der vorstehenden Ansprüche, wobei der lokale, nicht verklebte Bereich (31) mindestens eine seitliche Abmessung in der Ebene der Klebgrenzfläche (3) von weniger als 300 Mikrometern aufweist.

13. Verfahren zum Übertragen nach einem der vorstehenden Ansprüche, wobei der lokale nicht verklebte Bereich (31) in einem zentralen Bereich der verklebten Anordnung (100) in der Ebene der Klebgrenzfläche (3) lokalisiert ist.

14. Verfahren zum Übertragen nach einem der vorstehenden Ansprüche, wobei der Dünnfilm (10), die aus dem Donatorsubstrat (1) stammt, aus monokristallinem Silizium besteht und das Trägersubstrat (2) monokristallines Silizium umfasst, um eine gestapelte Struktur (110) vom SOI-Typ zu bilden.

## Claims

1. A method for transferring a thin layer (10) onto a support substrate (2), comprising:
- the provision of a bonded assembly (100) comprising a donor substrate (1) and the support substrate (2), assembled by direct bonding at their respective front faces (1a, 2a), along a bonding interface (3), wherein the bonded assembly (100) has a local non-bonded zone (31) within this bonding interface (3), wherein the donor substrate (1) further comprises a buried fragile plane (11),
- the separation along the buried fragile plane (11), initiated at the local non-bonded zone (31) after growth of microcracks in said plane (11) by thermal activation, wherein the separation leads to the transfer of a thin layer (10) from the donor substrate (1) onto the support substrate (2),
wherein the method is **characterized in that** the local non-bonded zone (31) is solely generated by a rough zone (31a), deliberately produced on at least one of the front faces (1a, 2a) of the donor substrate (1) and the support substrate (2) before their assembly, wherein said rough zone (31a) is free of topology and has a predetermined roughness of amplitude between 0.5 nm RMS and 60.0 nm RMS.

2. The transfer method according to the preceding claim, wherein the rough zone is produced by at least one laser shot, generating only a surface melting, in the first 1 to 30 nanometers, of a material making up the donor substrate (1) and/or the support substrate (2), on the side of their respective front face (1a, 2a).

3. The transfer method according to the preceding claim, wherein the laser shot has a pulse duration, comprised between 1 ns and 1000 ns, preferably comprised between 10 ns and 500 ns.

4. The transfer method according to the preceding claim, wherein the laser shot is carried out with a laser having a wavelength of 308 nm, and having an energy density of between 1.8 J/cm² and 2.5 J/cm².

5. The transfer method according to any one of the three preceding claims, wherein a laser shot irradiates a circular surface, with a diameter of less than 200 micrometers.

6. The transfer method according to the preceding claim, wherein the rough zone (31a) is produced from a plurality of laser shots, for example between two and fifteen laser shots, wherein the adjacent circular surfaces, that are irradiated by the successive laser shots, are tangent or have a percentage of overlap between 1 % and 95 %.

7. The transfer method according to any one of the preceding claims, wherein:
- the front face (1a, 2a), on which the rough zone (31a) is produced, is made of monocrystalline silicon, and the predetermined roughness has an amplitude between 0.5 nm RMS and 4.0 nm RMS, preferably between 1.0 nm RMS and 2.5 nm RMS, or
- the front face (1a, 2a), on which the rough zone (31a) is produced, is made of polycrystalline silicon, and the predetermined roughness has an amplitude between 0.5 nm RMS and 5.0 nm RMS, preferably between 2.0 nm RMS and 5.0 nm RMS, or
- the front face (1a, 2a), on which the rough zone (31a) is produced, is made of silicon oxide, and the predetermined roughness has an amplitude between 1.0 nm RMS and 60.0 nm RMS.

8. The transfer method according to any one of the preceding claims, wherein the rough zone (31a) is produced on the front face (1a) of the donor substrate (1), before the formation of the buried fragile plane (11) in said donor substrate (1).

9. The transfer method according to the preceding claim, wherein:
- the donor substrate (1) is formed from a first material at its front face (1a), and a preliminary rough zone is produced on the surface of said material, and
- thermal oxidation of the first material of the donor substrate (1) is carried out after the production of the preliminary rough zone and before the formation of the buried fragile plane (11), to form an insulating layer which will be assembled on the support substrate (2) in the bonded assembly (100), said insulating layer comprising, on its free face, the rough zone (31a) directly above the preliminary rough zone.

10. The transfer method according to any one of claims 1 to 7, wherein:
- the support substrate (2) is formed from a first material at its front face (2a), and a preliminary rough zone is produced on the surface of said material, and
- thermal oxidation of the first material of the support substrate (2) is carried out after the production of the preliminary rough zone, to form an insulating layer which will be assembled on the donor substrate (1) in the bonded assembly (100), wherein said insulating layer comprises, on its free face, the rough zone (31a) directly above the preliminary rough zone.

11. The transfer method according to any one of the preceding claims, wherein the local non-bonded zone (31) has a shape, in the plane of the bonding interface (3), at least a portion of the contour of which has a radius of curvature less than the radius of a circular bonding defect of the same surface.

12. The transfer method according to any one of the preceding claims, wherein the non-bonded local zone (31) has at least one lateral dimension, in the plane of the bonding interface (3), of less than 300 micrometers.

13. The transfer method according to any one of the preceding claims, wherein the non-bonded local zone (31) is located in a central region of the bonded assembly (100), in the plane of the bonding interface (3).

14. The transfer method according to any one of the preceding claims, wherein the thin layer (10), originating from the donor substrate (1), is made of monocrystalline silicon and the support substrate (2) comprises monocrystalline silicon, to form a stacked structure (110) of the SOI type.
